# EUROPÄISCHE PATENTSCHRIFT

(11) **EP 0 429 905 B1**
(45) Veröffentlichungstag und Bekanntmachung des Hinweises auf die Patenterteilung: **14.06.1995**
(21) Anmeldenummer: 90121327.2
(22) Anmeldetag: 07.11.1990
(51) Int. Cl.: H01L 21/283, C23C 14/34, C23C 14/00

(54) **Verfahren zur Verringerung der Reflektivität von Sputter-Schichten**
Process for reducing the reflectivity of sputtered layers
Procédé pour réduire la réflectivité de couches pulvérisées

(30) Priorität: 30.11.1989 DE 3939636
(43) Veröffentlichungstag der Anmeldung: 05.06.1991
(73) Patentinhaber: SIEMENS AKTIENGESELLSCHAFT, 80333 München (DE)
(72) Erfinder: Joswig, Hellmut, Dr., W-8000 München 90 (DE)

(56) Entgegenhaltungen:
- GB-A- 830 391
- GB-A- 2 135 697
- GB-A- 2 138 026
- US-A- 4 113 599
- US-A- 4 125 446
- US-A- 4 420 385

## Beschreibung

Die vorliegende Erfindung betrifft ein Verfahren zur Verringerung der Reflektivität von durch Sputtern hergestellten Schichten nach dem Oberbegriff des Patentanspruches 1.

In der Halbleiter-Mikroelektronik gewinnt mit steigender Strukturverkleinerung die maßhaltige und reproduzierbare Strukturierung von dünnen Schichten an Bedeutung. Insbesondere die Fototechnik im Sub-»m-Bereich von Schichten mit reflektierender Oberfläche stellt ein Problem dar.

Bei hoher Reflektivität derartiger Schichten werden in einem Fototechnik-Prozeß auch Teile des Fotolacks belichtet, die an sich nicht belichtet werden sollten. Dies führt zu Ausfransungen oder Einkerbungen im Fotolack, die sich nach der Ätzung in einer zu strukturierenden Schicht wiederfinden. Bei metallischen Schichten können elektrische Kurzschlüsse benachbarter Bahnen oder Bahnabrisse die Folge sein.

Eine weitere Schwierigkeit bei der Fototechnik auf reflektierenden Schichten ist die Bildung von stehenden Wellen im Fotolack und eine dadurch bedingte ungleichmäßige Belichtung des Lacks, wodurch Linienbreitenschwankungen bewirkt werden.

Die vorstehend angesprochenen Probleme treffen insbesondere auf die in der Mikroelektronik verwendeten metallischen Schichten zu. Hierzu zählen beispielsweise die refraktären Metalle, deren Silizide, sowie Aluminium und Aluminiumlegierungen, wobei die Herstellung dieser metallischen Schichten in aller Regel durch Sputtern erfolgt.

Zur Vermeidung der mit hoher Reflektivität verbundenen Nachteile im oben beschriebenen Sinne hat man bisher auf die zu strukturierende Schicht verschiedene Arten von Antireflexschichten aufgebracht. Hierzu zählen z.B. stöchiometrisches und nichtstöchiometrisches Siliziumnitrid, amorphes Silizium, TiW, V, TiN oder spin-on-Schichten mit absorbierendem Fotolack.

Ein typischer Prozeßablauf bei der Strukturierung einer Schicht mittels Fototechnik ist dabei der folgende: Es wird zunächst die zu strukturierende Schicht und sodann auf dieser eine Antireflexschicht abgeschieden. Sodann erfolgt eine Belackung, Belichtung, Entwicklung sowie eine Ätzung der zu strukturierenden Schicht, wonach der Lack und die Antireflexschicht entfernt und die durch Ätzung strukturierte Schicht nachbehandelt wird. Die beiden letztgenannten Schritte der Antireflexschicht sowie der Nachbehandlung der strukturieren Schicht können zwar in manchen Fällen zu einem Prozeßschritt zusammengefaßt werden. Bei der Nachbehandlung der strukturierten Schicht handelt es sich beispielsweise um eine Temperung, wie sie bei Aluminium und Aluminiumlegierungen bei etwa 400 bis 500°C durchgeführt wird, oder um einen Hochtemperaturprozeß, wie er bei Siliziden zur Anwendung kommt ("Silizierung" bei 600 bis 1000°C).

In US-A-4 125 446 ist ein Verfahren offenbart, durch das sich die Reflektivität von gesputterten Aluminiumschichten von mehr als 0.5 »m Dicke kontrollieren läßt.

Der vorliegenden Erfindung liegt die Aufgabe zugrunde, ein Verfahren der in Rede stehenden Art anzugeben, bei dem der mit einer Antireflexschicht verbundene zusätzliche Aufwand vermieden wird.

Diese Aufgabe wird bei einem Verfahren der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird im folgenden anhand von Ausführungsbeispielen näher erläutert.

Bei dem zu ändernden Prozeßparameter eines Sputterprozesses, bei dem sich in der Sputter-Schicht eine oberflächennahe Teilschicht mit verringerter Reflektivität bei im wesentlichen gleich bleibenden übrigen Eigenschaften der Schicht ergibt, kann es sich gemäß einer Ausführungsform der Erfindung um die Sputteratmosphäre handeln, die durch Zusatz eines reaktiven Stoffes geändert wird. Der Begriff "reaktiv" bezeichnet hier den Sachverhalt, daß der Zusatz-Stoff in die Sputter-Schicht eingebaut wird. Als reaktiver Stoff kommt dabei in Weiterbildung der Erfindung ein Fremdgas, insbesondere Stickstoff oder Sauerstoff in Frage, das der Sputter-Atmosphäre zugesetzt wird.

Durch den Zusatz eines derartigen Fremdgases am Ende des Sputterprozesses wird die Oberfläche der Sputter-Schicht so geändert, daß sich eine erhebliche Verminderung der Reflektivität der Schicht ergibt. Andererseits wird die Schicht jedoch nur in einem dünnen Bereich an der Oberfläche modifiziert, so daß andere Schichteigenschaften, z.B. der Schichtwiderstand, sich im wesentlichen nicht ändern.

Ein typischer Prozeßablauf zur Strukturierung einer solchen Sputter-Schicht ist dabei der folgende: Es wird zunächst die zu strukturierende Schicht durch Sputtern abgeschieden, wobei sich durch Zusatz des Fremdgases eine oberflächennahe Teilschicht mit verminderter Reflektivität ergibt. Sodann erfolgt wieder eine Belackung, Belichtung, Entwicklung sowie eine Ätzung zur Strukturierung der Sputter-Schicht, wonach wiederum der Lack entfernt und die strukturierte Schicht nachbehandelt wird.

Durch das erfindungsgemäße Verfahren ergibt sich also der Vorteil, daß zwei Prozeßschritte, nämlich die Abscheidung und die Entfernung der Antireflexschicht entfallen können, woraus sich insgesamt eine Vereinfachung und eine Verbilligung aufgrund eines verminderten Anlagenbedarfes eines Fertigungsprozesses ergibt.

Zur weiteren Erläuterung der erfindungsgemäßen Vorteile seien eine durch konventionelles Sputtern und eine nach dem erfindungsgemäßen Verfahren hergestellte Molybdänsilizidschicht miteinander verglichen. Beide Schichten seien in derselben Sputter-Anlage unter Benutzung desselben Sputter-Targets hergestellt. Als Sputter-Atmosphäre wird von einer Argon-Atmosphäre ausgegangen, wobei für die erfindungsgemäß hergestellte Schicht am Ende des Sputter-Prozesses ein Stickstoff-Zusatz vorhanden ist. Typische Prozeßparameter sind dabei für die nach dem erfindungsgemäßen Verfahren hergestellte Schicht eine Sputterleistung von 1 bis 10 kW, ein Druck von 0.13 bis 1.3 Pa (1 bis 10 mTorr), ein Anteil des Fremdgases Stickstoff von 5 bis 100% und eine Dicke der oberflächennahen Teilschicht mit verminderter Reflektivität von 7 bis 30 nm.

Prozeßparameter, insbesondere die Art und der Anteil des Stickstoffs und die Dauer, für die Stickstoff am Ende des Sputter-Prozesses zugesetzt wird, lassen sich im Hinblick auf die Reflektivitätsverminderung bei der gewünschten Wellenlänge optimieren.

Für eine Wellenlänge von 436 nm ergibt sich dabei für die erfindungsgemäß hergestellte Schicht gegenüber der konventionell hergestellten Schicht eine Reduzierung der Reflektivität von 52 auf 14%. Bei dieser erheblichen Änderung der Reflektivität einer oberflächennahen Teilschicht ergibt sich keine wesentliche Änderung des Schichtwiderstandes der Gesamtschicht.

Bei der Änderung eines Prozeßparameters des Sputter-Prozesses muß es sich nicht allein um eine Änderung der Sputter-Atmosphäre durch Zusatz eines reaktiven Stoffes handeln. Gemäß einer weiteren Ausführungsform der Erfindung ist es stattdessen auch möglich, als Prozeß den Sputter-Druck zu ändern, insbesondere hinaufzusetzen.

## Patentansprüche

1. Verfahren zur Verringerung der Reflektivität von in der Halbleitertechnik zu strukturierenden, durch Sputtern hergestellten Schichten, **dadurch gekennzeichnet**, daß am Ende des Sputter-Prozesses zur Ablagerung einer Schicht ein Prozeßparameter so geändert wird, daß sich an der Oberfläche der Schicht eine Teilschicht von einer Dicke von 7 bis 30 nm mit verringerter Reflektivität bei im wesentlichen gleich bleibendem Schichtwiderstand der Schicht ergibt.

2. Verfahren nach Anspruch 1, **dadurch gekennzeichnet**, daß als Prozeßparameter die Sputter-Atmosphäre durch Zusatz eines reaktiven Stoffes geändert wird.

3. Verfahren nach Anspruch 2, **dadurch gekennzeichnet**, daß als reaktiver Stoff ein Fremdgas, insbesondere Stickstoff oder Sauerstoff, zugesetzt wird.

4. Verfahren nach Anspruch 1, **dadurch gekennzeichnet**, daß als Prozeßparameter der Sputter-Druck geändert, insbesondere hinaufgesetzt wird.

## Claims

1. Process for reducing the reflectivity of layers which can be structured in semiconductor technology and are produced by sputtering, characterized in that, at the end of the sputtering process for depositing a layer, a process parameter is varied such that a partial layer, having a thickness of 7 to 30 nm and having reduced reflectivity is produced on the surface of the layer with the layer resistance of the layer remaining essentially constant.

2. Process according to Claim 1, characterized in that the sputtering atmosphere is varied, by the addition of a reactive material, as the process parameter.

3. Process according to Claim 2, characterized in that a different gas, preferably nitrogen or oxygen, is added as the reactive material.

4. Process according to Claim 1, characterized in that the sputtering pressure is varied, preferably being raised, as the process parameter.

## Revendications

1. Procédé pour réduire le coefficient de réflexion de couches devant être structurées dans la technique des semiconducteurs et fabriquées par pulvérisation cathodique, caractérisé par le fait qu'à la fin de l'opération de pulvérisation cathodique pour le dépôt d'une couche, on modifie un paramètre opératoire de telle sorte qu'une couche partielle d'une épaisseur de 7 à 30 nm, ayant un coefficient de réflexion réduit se forme à la surface de la couche, pour une résistance de la couche restant sensiblement identique.

2. Procédé suivant la revendication 1, caractérisé par le fait qu'on modifie, comme paramètre opératoire, l'atmosphère de pulvérisation cathodique, par addition d'une substance réactive.

3. Procédé suivant la revendication 2, caractérisé par le fait qu'on ajoute, comme substance réactive, un gaz étranger, notamment de l'azote ou de l'oxygène.

4. Procédé suivant la revendication 1, caractérisé par le fait qu'on modifie et notamment on augmente la pression de pulvérisation cathodique, en tant que paramètre opératoire.
